# EUROPÄISCHE PATENTSCHRIFT

(11) **EP 2 907 119 B1**
(45) Veröffentlichungstag und Bekanntmachung des Hinweises auf die Patenterteilung: **22.03.2017**
(21) Anmeldenummer: 13801485.7
(22) Anmeldetag: 20.11.2013
(51) Int. Cl.: G08C 17/02, H04L 1/08, B61L 3/12

(54) **ANORDNUNG MIT EINEM AKTUATOR**
ARRANGEMENT WITH AN ACTUATOR
AGENCEMENT AVEC ACTIONNEUR

(30) Priorität: 14.12.2012 DE 102012223271
(43) Veröffentlichungstag der Anmeldung: 19.08.2015
(73) Patentinhaber: Siemens Aktiengesellschaft, 80333 München (DE)
(72) Erfinder: SCHAFFRATH, Niklas, 10627 Berlin (DE)
(86) Internationale Anmeldenummer: PCT/EP2013/074252
(87) Internationale Veröffentlichungsnummer: WO 2014/090530

(56) Entgegenhaltungen:
- EP-A2- 1 962 442
- WO-A1-2010/057655
- DE-A1- 1 513 172
- DE-A1-102004 040 059
- US-A1- 2007 192 668

## Beschreibung

Die Erfindung bezieht sich auf eine Anordnung zum Übersenden eines Steuerbefehls für einen Aktuator.

Entsprechende Anordnungen sind aus den veröffentlichten Patentanmeldungen DE 10 2004 040 059 A1 sowie EP 1 962 442 A2 bekannt.

Der Erfindung liegt die Aufgabe zugrunde, eine Anordnung anzugeben, die unter Verwendung einfacher Standardkomponenten herstellbar ist, aber dennoch eine sichere Übertragung von Steuerbefehlen ermöglicht.

Diese Aufgabe wird erfindungsgemäß durch eine Anordnung mit den Merkmalen gemäß Patentanspruch 1 gelöst. Vorteilhafte Ausgestaltungen der erfindungsgemäßen Anordnung sind in Unteransprüchen angegeben.

Danach wird erfindungsgemäß vorgeschlagen eine Anordnung mit einem Aktuator, zumindest einer Sendeeinrichtung zum Senden von Steuertelegrammen, die jeweils einen vorgegebenen Steuerbefehl für den Aktuator enthalten oder als solche den vorgegebenen Steuerbefehl selbst bilden, mindestens zwei Empfangseinrichtungen zum Empfangen der Steuertelegramme und Erzeugen eines Steuersignals für den Aktuator, und einer die Empfangseinrichtungen mit dem Aktuator verbindenden Entscheidereinrichtung, die ein Umsetzen der Steuersignale der Empfangseinrichtungen durch den Aktuator mittels eines Freigabesignals ausschließlich dann erlaubt, wenn von allen Empfangseinrichtungen oder zumindest einer vorgegebenen Mindestzahl an Empfangseinrichtungen das Steuersignal vorliegt, wobei die Sendeeinrichtung derart ausgestaltet ist, dass sie den vorgegebenen Steuerbefehl jeweils an jede Empfangseinrichtung mit einem empfängerindividuellen Steuertelegramm übersendet, wobei jedes empfängerindividuelle Steuertelegramm jeweils mit einer Kontrollangabe versehen wird, die die fortlaufende Telegrammnummer des jeweils gesendeten Steuertelegramms in verschlüsselter oder unverschlüsselter Form angibt, und wobei jede der mindestens zwei Empfangseinrichtungen derart ausgestaltet ist, dass sie ein empfangenes Steuertelegramm anhand der Kontrollangabe als für sie gültig akzeptiert, wenn die Kontrollangabe eine Telegrammnummer angibt, die der empfängerseitig erwarteten fortlaufenden Telegrammnummer entspricht, und im Falle des Empfangs eines gültigen Steuertelegramms das Steuersignal für den Aktuator jeweils für eine vorgegebene Zeitdauer erzeugt.

Ein wesentlicher Vorteil der erfindungsgemäßen Anordnung besteht darin, dass bei dieser eine fehlerhafte Übertragung und Umsetzung von Steuerbefehlen sehr unwahrscheinlich ist. Dies ist konkret darauf zurückzuführen, dass eine Umsetzung eines Steuerbefehls nur dann erfolgt, wenn zwei Empfangseinrichtungen jeweils empfängerindividuelle Steuertelegramme erhalten, die mit einer gültigen bzw. korrekten telegrammnummernindividuellen und empfängerindividuellen Kontrollangabe versehen sind. Durch das Übertragen einer telegrammnummernindividuellen Kontrollangabe lässt sich überprüfen, ob die eingehenden Telegramme in der richtigen Reihenfolge übersandt und empfangen werden und somit eine gültige Telegrammsequenz bilden. Nur wenn jede der beiden Empfangseinrichtungen jeweils empfängerindividuell eine korrekte Telegrammsequenz erhält, wird es zu einer Umsetzung eines Steuerbefehls kommen.

Ein weiterer wesentlicher Vorteil der erfindungsgemäßen Anordnung besteht darin, dass das bereits erwähnte hohe Maß an Übertragungssicherheit mit technisch einfachen, kommerziell erhältlichen und kostengünstigen Komponenten erreichbar ist.

Aufgrund der bei der erfindungsgemäß vorgesehenen Anordnung erreichbaren Übertragungssicherheit ist es in vorteilhafter Weise möglich, diese auch im Bereich der Schienenfahrzeugtechnik einzusetzen. So ist es beispielsweise möglich, Steuerbefehle zu übermitteln, mit denen sich eine Bremse eines Schienenfahrzeugs lösen lässt.

Bezüglich der Ausgestaltung der Sendeeinrichtung wird es als vorteilhaft angesehen, wenn diese einen Kontrollangabengenerator aufweist, der für jede Empfangseinrichtung in Abhängigkeit von der fortlaufenden Telegrammnummer des zu sendenden Steuertelegramms und einer empfängerindividuellen Saatangabe oder einem empfängerindividuellen Saatwert die Kontrollangabe empfängerindividuell erzeugt.

Besonders einfach und damit vorteilhaft lassen sich Kontrollangaben auf der Basis von Pseudozufallszahlen generieren; demgemäß wird es als vorteilhaft angesehen, wenn der Kontrollangabengenerator einen Pseudozufallszahlengenerator aufweist und die empfängerindividuellen Saatwerte empfängerindividuelle Startwerte für den Pseudozufallszahlengenerator sind und der Kontrollangabengenerator empfängerindividuelle Pseudozufallszahlensequenzen bildet, die der Telegrammnummernsequenz zugeordnet werden, und als empfängerindividuelle Kontrollangabe die der aktuellen Telegrammnummer des zu sendenden Telegramms entsprechende Pseudozufallszahl der jeweiligen empfängerindividuellen Pseudozufallszahlensequenz ausgewählt wird.

Falls Pseudozufallszahlen als Kontrollangabe verwendet werden, wird es empfängerseitig als vorteilhaft angesehen, wenn jede Empfangseinrichtung jeweils einen Referenzpseudozufallszahlengenerator und eine Vergleichseinrichtung aufweist, wobei der Referenzpseudozufallszahlengenerator geeignet ist, mit dem empfängerindividuellen Startwert die empfängerindividuelle Pseudozufallszahlensequenz zu generieren, und wobei die Vergleichseinrichtung derart ausgestaltet ist, dass sie für jedes empfangene Telegramm anhand der fortlaufenden Telegrammnummer prüft, ob die übermittelte Pseudozufallszahl der erwarteten Pseudozufallszahl gemäß Pseudozufallszahlensequenz entspricht und den Steuerbefehl erzeugt, wenn der Vergleich der Kontrollangabe eine Übereinstimmung zeigt.

Vorzugsweise ist die Vergleichseinrichtung derart ausgestaltet, dass sie die übermittelte Pseudozufallszahl als erwartete Pseudozufallszahl gemäß Pseudozufallszahlensequenz ansieht, wenn diese in einen durch eine vorgegebene Anzahl an sequenzmäßig aufeinanderfolgenden Pseudozufallszahlen definierten Sequenzabschnitt fällt, in dem auch die empfängerseitig anhand der fortlaufenden Telegrammnummer erwartete Pseudozufallszahl liegt.

Zusätzlich oder alternativ zu einem Pseudozufallszahlengenerator kann der Kontrollangabengenerator der Sendeeinrichtung einen Hashwertbildner umfassen, der mit der aktuellen Telegrammnummer der Telegrammnummernsequenz und einer empfängerindividuellen Hashfunktion als empfängerindividuelle Kontrollangabe einen empfängerindividuellen Hashwert erzeugt.

Im Falle einer Übertragung empfängerindividueller Hashwerte wird es als vorteilhaft angesehen, wenn jede Empfangseinrichtung jeweils einen Referenzhashwertbildner und eine Vergleichseinrichtung aufweist, wobei der Referenzhashwertbildner geeignet ist, mit der empfängerindividuellen Hashfunktion und der anhand der fortlaufenden Telegrammnummer des zuvor empfangenen Telegramms erwarteten Telegrammnummer des nächsten Telegramms einen Referenzhashwert zu generieren, und wobei die Vergleichseinrichtung derart ausgestaltet ist, dass sie für jedes empfangene Telegramm prüft, ob der übermittelte Hashwert dem Referenzhashwert entspricht und den Steuerbefehl erzeugt, wenn der Vergleich eine Übereinstimmung zeigt.

Wie bereits eingangs erwähnt, kann die Anordnung im Bereich der Eisenbahntechnik eingesetzt werden. In einem solchen Fall wird es als vorteilhaft angesehen, wenn die Anordnung eine Steueranordnung zum Steuern eines Aktuators eines Schienenfahrzeugs bildet und die Sendeeinrichtung derart ausgebildet ist, dass sie als Steuerbefehl einen Befehl zum Beibehalten einer aktiven Aktuatorstellung erzeugt, und der Aktuator derart ausgestaltet ist, dass er in seine passive Aktuatorstellung zurückfällt, wenn von der Entscheidereinrichtung kein Freigabesignal vorliegt.

Um einen Fehler bei der Übertragung der Datentelegramme sendeseitig erkennen zu können, wird es als vorteilhaft angesehen, wenn die Empfangseinrichtungen derart ausgestaltet sind, dass sie den Empfang von Steuertelegrammen jeweils durch ein Übersenden eines Quittungstelegramms mit empfänger- und telegrammnummernindividueller Kontrollangabe an die Sendeeinrichtung quittieren, und die Sendeeinrichtung derart ausgebildet ist, dass sie das Senden weiterer Steuertelegramme einstellt, wenn die Differenz zwischen der Anzahl gesendeter Steuertelegramme und der Anzahl erhaltener Quittungstelegramme einen vorgegebenen Differenzwert überschreitet.

Besonders einfach und kostengünstig lässt sich die Entscheidereinrichtung durch ein UND-Glied bilden, das das Freigabesignal für den Aktuator ausschließlich dann bildet, wenn alle Empfangseinrichtungen das Steuersignal erzeugt haben.

Die Erfindung bezieht sich darüber hinaus auf eine Empfangsanordnung für eine Anordnung, wie sie oben beschrieben worden ist. Erfindungsgemäß ist vorgesehen, dass die Empfangsanordnung einen Aktuator, mindestens zwei Empfangseinrichtungen zum Empfangen von Steuertelegrammen und Erzeugen eines Steuersignals für den Aktuator, und eine die Empfangseinrichtungen mit dem Aktuator verbindenden Entscheidereinrichtung aufweist, die ein Umsetzen der Steuersignale der Empfangseinrichtungen durch den Aktuator mittels des Freigabesignals ausschließlich dann erlaubt, wenn von allen Empfangseinrichtungen oder zumindest einer vorgegebenen Mindestzahl an Empfangseinrichtungen das Steuersignal vorliegt, wobei jede der mindestens zwei Empfangseinrichtungen derart ausgestaltet ist, dass sie ein empfangenes Steuertelegramm anhand einer Kontrollangabe als für sie gültig akzeptiert, wenn die Kontrollangabe eine Telegrammnummer angibt, die der empfängerseitig erwarteten fortlaufenden Telegrammnummer entspricht, und im Falle des Empfangs eines gültigen Steuertelegramms das Steuersignal für den Aktuator jeweils für eine vorgegebene Zeitdauer erzeugt.

Bezüglich der Vorteile der erfindungsgemäßen Empfangsanordnung sei auf die oben aufgeführten Vorteile der erfindungsgemäßen Anordnung mit Sendeeinrichtung verwiesen.

Die Erfindung bezieht sich darüber hinaus auf ein Verfahren zum Betreiben einer Anordnung, wie sie oben beschrieben worden ist. Erfindungsgemäß ist vorgesehen ein Verfahren zum Betreiben einer Anordnung mit einem Aktuator, einer Sendeeinrichtung, mindestens zwei Empfangseinrichtungen, und einer die Empfangseinrichtungen mit dem Aktuator verbindenden Entscheidereinrichtung, wobei bei dem Verfahren:
- mit der Sendeeinrichtung Steuertelegramme gesendet werden, die jeweils einen vorgegebenen Steuerbefehl für den Aktuator enthalten oder als solche den vorgegebenen Steuerbefehl selbst bilden,
- mit den mindestens zwei Empfangseinrichtungen die Steuertelegramme empfangen werden und Steuersignale für den Aktuator erzeugt werden, und
- die Entscheidereinrichtung ein Umsetzen der Steuersignale der Empfangseinrichtungen durch den Aktuator mittels eines Freigabesignals ausschließlich dann erlaubt, wenn von allen Empfangseinrichtungen oder zumindest einer vorgegebenen Mindestzahl an Empfangseinrichtungen das Steuersignal vorliegt,
- wobei die Sendeeinrichtung den vorgegebenen Steuerbefehl jeweils an jede Empfangseinrichtung mit einem empfängerindividuellen Steuertelegramm übersendet, wobei jedes empfängerindividuelle Steuertelegramm jeweils mit einer Kontrollangabe versehen wird, die die fortlaufende Telegrammnummer des jeweils gesendeten Steuertelegramms in verschlüsselter oder unverschlüsselter Form angibt, und
- wobei jede der mindestens zwei Empfangseinrichtungen ein empfangenes Steuertelegramm anhand der Kontrollangabe als für sie gültig akzeptiert, wenn die Kontrollangabe eine Telegrammnummer angibt, die der empfängerseitig erwarteten fortlaufenden Telegrammnummer entspricht, und im Falle des Empfangs eines gültigen Steuertelegramms das Steuersignal für den Aktuator jeweils für eine vorgegebene Zeitdauer erzeugt.

Bezüglich der Vorteile des erfindungsgemäßen Verfahrens sei auf die oben aufgeführten Vorteile der erfindungsgemäßen Anordnung verwiesen, da die Vorteile der erfindungsgemäßen Anordnung denen des erfindungsgemäßen Verfahrens entsprechen.

Die Erfindung wird nachfolgend anhand von Ausführungsbeispielen näher erläutert; dabei zeigen beispielhaft
- Figur 1: ein Ausführungsbeispiel für eine Anordnung, bei der Kontrollangaben für empfängerindividuelle Steuertelegramme durch Pseudozufallszahlen gebildet werden,
- Figur 2: eine Ausführungsvariante der Anordnung gemäß Figur 1, bei der Empfangseinrichtungen Quittungssignale senden, mit denen sie den Empfang von Steuertelegrammen quittieren,
- Figur 3: ein Ausführungsbeispiel für eine Anordnung, bei der Kontrollangaben für empfängerindividuelle Steuertelegramme mittels Hashfunktionen gebildet werden, und
- Figur 4: ein Ausführungsbeispiel für eine Anordnung, bei der der Aktuatorzustand eines Aktuators der Anordnung über einen separaten Rückkopplungszweig rückgemeldet wird.

In den Figuren werden der Übersicht halber für identische oder vergleichbare Komponenten stets dieselben Bezugszeichen verwendet.

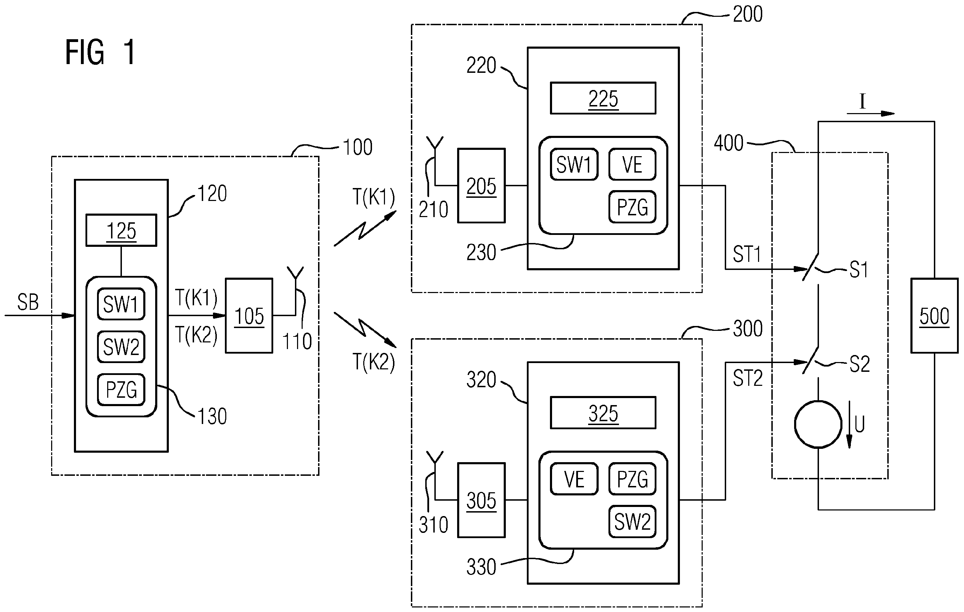

Die Figur 1 zeigt eine Anordnung mit einer Sendeeinrichtung 100, zwei Empfangseinrichtungen 200 und 300, einer Entscheidereinrichtung 400 sowie einem Aktuator 500.

Die Sendeeinrichtung 100 umfasst ein Funkmodul 105 mit einer Antenne 110 und eine Recheneinrichtung 120. Die Recheneinrichtung 120 weist einen Prozessor 125 auf, der mit einem Speicher 130 der Recheneinrichtung 120 in Verbindung steht.

In dem Speicher 130 der Recheneinrichtung 120 ist ein Generatormodul PZG abgespeichert, das bei Ausführung durch den Prozessor 125 Pseudozufallszahlensequenzen bilden kann. Das Generatormodul PZG bildet somit also bei Ausführung durch den Prozessor 125 einen Pseudozufallszahlengenerator.

Das Generatormodul PZG kann zur Erzeugung unterschiedlicher Pseudozufallszahlensequenzen mit unterschiedlichen Startwerten gestartet werden, von denen zwei Startwerte, nämlich der Startwert SW1 und der Startwert SW2 in dem Speicher 130 abgespeichert sind. Der Startwert SW1 ist der Empfangseinrichtung 200 zugeordnet, und der Startwert SW2 ist der Empfangseinrichtung 300 zugewiesen.

Die Figur 1 zeigt außerdem den Aufbau der Empfangseinrichtung 200. Man erkennt ein Funkmodul 205 mit einer daran angeschlossenen Antenne 210. Mit dem Funkmodul 205 steht eine Recheneinrichtung 220 in Verbindung, die einen Prozessor 225 sowie einen Speicher 230 aufweist.

In dem Speicher 230 ist ein Generatormodul PZG abgespeichert, das mit dem Generatormodul PZG der Sendeeinrichtung 100 identisch ist oder zumindest identische Pseudozufallszahlensequenzen wie dieses bilden kann. Das Generatormodul PZG im Speicher 230 dient zur Erzeugung einer Referenzpseudozufallszahlensequenz, die mit der Pseudozufallszahlensequenz der Sendeeinrichtung 100 identisch ist. Um in der Empfangseinrichtung 200 dieselbe Pseudozufallszahlensequenz wie in der Sendeeinrichtung 100 erzeugen zu können, ist in dem Speicher 230 der empfängerindividuelle Startwert SW1 für die Empfangseinrichtung 200 abgespeichert.

In dem Speicher 230 ist darüber hinaus ein Vergleichsmodul VE abgespeichert, das einen Vergleich von Pseudozufallszahlen ermöglicht. Die Funktion des Vergleichsmoduls VE wird weiter unten noch näher erläutert.

In der Figur 1 lässt sich auch der Aufbau der Empfangseinrichtung 300 erkennen. Man sieht ein Funkmodul 305 mit einer Antenne 310 sowie eine Recheneinrichtung 320. Die Recheneinrichtung 320 umfasst einen Prozessor 325 sowie einen Speicher 330. Vom konstruktiven bzw. hardwaremäßigen Aufbau entspricht die Empfangseinrichtung 300 somit der Empfangseinrichtung 200.

In dem Speicher 330 ist ein Generatormodul PZG abgespeichert, das von der Arbeitsweise her dem Generatormodul PZG in der Empfangseinrichtung 200 sowie dem Generatormodul PZG in der Sendeeinrichtung 100 entspricht. Das Generatormodul PZG im Speicher 330 erzeugt bei Ausführung durch den Prozessor 325 unter Berücksichtigung des im Speicher 330 abgespeicherten empfängerindividuellen Startwerts SW2 eine Referenzpseudozufallszahlensequenz, die der Pseudozufallszahlensequenz der Sendeeinrichtung 100 entspricht, wenn das Generatormodul PZG dort mit dem Startwert SW2 betrieben wird.

In dem Speicher 330 ist darüber hinaus ein Vergleichsmodul VE abgespeichert, das dem Vergleichsmodul VE der Empfangseinrichtung 200 entspricht. Die Funktion des Vergleichsmoduls VE der Empfangseinrichtung 300 wird weiter unten noch näher erläutert.

Die beiden Empfangseinrichtungen 200 und 300 sind ausgangsseitig mit der Entscheidereinrichtung 400 verbunden. Die Entscheidereinrichtung 400 umfasst zwei Schalter S1 und S2, die elektrisch in Reihe geschaltet sind und ein logisches UND-Glied bilden. Die Entscheidereinrichtung 400 ist darüber hinaus mit einer Spannungsquelle U ausgestattet, die mit den beiden Schaltern S1 und S2 in Reihe liegt.

Die beiden Schalter S1 und S2 lassen sich über Steuersignale ST1 und ST2 der beiden Empfangseinrichtungen 200 und 300 aktivieren bzw. schließen, so dass die Entscheidereinrichtung 400 als Freigabesignal einen Strom I erzeugt, wenn entsprechende Steuersignale ST1 und ST2 anliegen und die beiden Schalter S1 und S2 geschlossen sind. Das Freigabesignal bzw. der Strom I fließt durch den Aktuator 500, der im Falle eines Stromflusses aktiviert wird.

Bei dem Aktuator 500 handelt es sich vorzugsweise um einen Aktuator, der lediglich bei Anliegen des Freigabesignals bzw. bei Stromfluss des Stromes I eine aktive Aktuatorstellung einnimmt und in seine passive Aktuatorstellung zurückfällt, wenn kein Strom I fließt bzw. kein Freigabesignal vorliegt. Bei dem Aktuator 500 kann es sich beispielsweise um eine Bremslöseeinrichtung für eine Bremse eines nicht näher dargestellten Schienenfahrzeugs handeln. Eine solche Bremslöseeinrichtung löst bei Vorliegen des Freigabesignals die Bremse des Schienenfahrzeugs und lässt bei Nichtvorliegen des Freigabesignals die Bremse in ihre Bremslage zurückfallen, so dass das Schienenfahrzeug bei Nichtvorliegen des Freigabesignals zwangsgebremst wird.

Die Anordnung gemäß Figur 1 lässt sich beispielsweise wie folgt betreiben:
Soll zum Aktivieren des Aktuators 500, beispielsweise zum Lösen einer Bremse eines Schienenfahrzeugs, ein Freigabesignal für den Aktuator 500 erzeugt werden, so kann ein entsprechender Steuerbefehl SB an die Sendeeinrichtung 100 angelegt werden. Sobald der Steuerbefehl SB anliegt, wird der Prozessor 125 Steuertelegramme T(K1) und T(K2) erzeugen, die zu den beiden Empfangseinrichtungen 200 und 300 übertragen werden und das Vorliegen des Steuerbefehls SB anzeigen.

Bei der Erzeugung der Steuertelegramme T(K1) und T(K2) wird der Prozessor 125 empfängerindividuelle Kontrollangaben erzeugen, die den Telegrammen T(K1) und T(K2) beigefügt werden und es den beiden Empfangseinrichtungen 200 und 300 erlauben, die Richtigkeit der Datentelegrammübertragung zu überprüfen. Dies soll anhand eines Beispiels näher erläutert werden:
Für die Erzeugung der Steuertelegramme T(K1) für die Empfangseinrichtung 200 wird der Prozessor 125 das Generatormodul PZG zur Erzeugung einer Pseudozufallszahlensequenz mit dem empfängerindividuellen Startwert SW1 der Empfangseinrichtung 200 aktivieren und für die Empfangseinrichtung 200 eine empfängerindividuelle Pseudozufallszahlensequenz erzeugen. Eine solche Pseudozufallszahlensequenz kann beispielsweise wie folgt lauten: 3242, 4253, 6784, 3892, ...

Nach Erzeugung der empfängerindividuellen Pseudozufallszahlensequenz wird der Prozessor 125 jedem Steuertelegramm T(K1), das zu der Empfangseinrichtung 200 übersandt wird, die jeweils nächste Pseudozufallszahl der Pseudozufallszahlensequenz zuordnen. Für das erste Steuertelegramm T(K1), das die Sendeeinrichtung 100 zu der Empfangseinrichtung 200 übersendet, wird dem Steuertelegramm T(K1) somit als Kontrollangabe die erste Pseudozufallszahl 3242 der Pseudozufallszahlensequenz zugeordnet. Soll das zweite Steuertelegramm T(K1) zu der Empfangseinrichtung 200 gesendet werden, wird demgemäß die Pseudozufallszahl 4253 als Kontrollangabe zugefügt. In entsprechender Weise werden die weiteren Pseudozufallszahlen 6784, 3892, ..., den weiteren Steuertelegrammen T(K1) zugewiesen, die zur Empfangseinrichtung 200 gesandt werden.

In entsprechender Weise wird der Prozessor 125 eine empfängerindividuelle Pseudozufallszahlensequenz für die Empfangseinrichtung 300 unter Berücksichtigung des empfängerindividuellen Startwertes SW2 erzeugen. Die Pseudozufallszahlensequenz für die Empfangseinrichtung 300 kann beispielsweise lauten: 7824, 9238, 4279, 4379, ... . Demgemäß wird der Prozessor 125 für das erste an die Empfangseinrichtung 300 zu sendende Steuertelegramm T(K2) also als Kontrollangabe die Pseudozufallszahl 7824 in das Steuertelegramm einfügen und das Steuertelegramm mit dieser Kontrollangabe an die Empfangseinrichtung 300 übersenden. Den weiteren Steuertelegrammen T(K2), die zur Empfangseinrichtung 300 übersandt werden, werden demgemäß die weiteren Pseudozufallszahlen der der Empfangseinrichtung 300 empfängerindividuell zugeordneten Pseudozufallszahlensequenz beigefügt, also die Pseudozufallszahlen 9238, 4279, 4379, usw., und zwar in der entsprechenden Reihenfolge, wie sie der Pseudozufallszahlensequenz entspricht.

Die Empfangseinrichtung 200 wird die empfängerindividuellen Steuertelegramme T(K1), die für sie bestimmt sind, anhand der in den Steuertelegrammen enthaltenen Pseudozufallszahlen erkennen. Darüber hinaus kann die Empfangseinrichtung 200 nachprüfen, ob die Steuertelegramme T(K1) in der richtigen Reihenfolge empfangen werden. Bei Empfang des ersten Steuertelegramms T(K1) wird der Prozessor 225 überprüfen, ob die in dem Steuertelegramm T(K1) enthaltene Pseudozufallszahl 3242 die richtige bzw. die erwartete Pseudozufallszahl ist. Um dies zu ermöglichen, wird der Prozessor 225 sein Generatormodul PZG aktivieren und unter Berücksichtigung des empfängerindividuellen Startwerts SW1 eine eigene Pseudozufallszahlensequenz bilden.

Anschließend wird er die eigene Pseudozufallszahlensequenz als Referenzpseudozufallszahlensequenz mit den Pseudozufallszahlen der eingehenden Steuertelegramme T(K1) vergleichen: Nach Empfang des ersten Steuertelegramms T(K1) wird der Prozessor 225 unter Zuhilfenahme des Vergleichsmoduls VE prüfen, ob die in dem Steuertelegramm T(K1) enthaltene Pseudozufallszahl 3242 mit der ersten Pseudozufallszahl der selbst generierten Pseudozufallszahlensequenz übereinstimmt. Falls dies der Fall ist, wird die Empfangseinrichtung 200 das Steuertelegramm T(K1) als gültig akzeptieren und ausgangsseitig ein Steuersignal ST1 erzeugen, mit dem der Schalter S1 geschlossen wird. Die Erzeugung des Steuersignals ST1 wird dabei jeweils für eine vorgegebene Zeitspanne von beispielsweise 100 Millisekunden erfolgen. Geht innerhalb dieser Zeitspanne kein weiteres Steuertelegramm T(K1) ein, mit dem der Steuerbefehl SB und die Aktivierung des Aktuators 500 weiter bestätigt wird, so wird die Erzeugung des Steuersignals ST1 beendet und der Schalter S1 wieder geöffnet.

In entsprechender Weise wird die Recheneinrichtung 220 die weiteren eingehenden Steuertelegramme T(K1) auf Gültigkeit überprüfen, indem sie jeweils die in den Steuertelegrammen T(K1) enthaltenen Pseudozufallszahlen dahingehend überprüft, ob diese mit der selbst erzeugten Referenzpseudozufallszahlensequenz korrespondieren. Für das zweite, dritte und vierte Steuertelegramm T(K1) wird der Prozessor 225 somit die Pseudozufallszahlen 4253, 6784 und 3892 erwarten und bei Empfang eines entsprechenden gültigen Steuertelegramms T(K1) jeweils wieder für die vorgegebene Zeitspanne bzw. Zeitdauer das Steuersignal ST1 erzeugen.

In entsprechender Weise arbeitet die Empfangseinrichtung 300, wobei diese jedoch im Unterschied zu der Empfangseinrichtung 200 mit ihrem eigenen empfängerindividuellen Startwert SW2 eine eigene Pseudozufallszahlensequenz bildet, die sich von der Pseudozufallszahlensequenz der Empfangseinrichtung 200 unterscheidet, da sich auch die beiden Startwerte SW1 und SW2 unterscheiden.

Sobald also die Empfangseinrichtung 300 ein erstes Steuertelegramm T(K2) empfängt, so wird der Prozessor 325 überprüfen, ob die in dem Steuertelegramm T(K2) enthaltene Pseudozufallszahl der erwarteten Pseudozufallszahl der selbst generierten Pseudozufallszahlensequenz entspricht. Da die Arbeitsweise des Generatormoduls PZG der Recheneinrichtung 320 der Arbeitsweise des Generatormoduls PZG der Recheneinrichtung 120 entspricht, wird in der Recheneinrichtung 320 somit eine Pseudozufallszahlensequenz 7824, 9238, 4279, 4379, ... gebildet, die mit der Pseudozufallszahlensequenz, die der Prozessor 125 unter Berücksichtigung des Startwerts SW2 bildet, übereinstimmt. Empfängt also die Empfangseinrichtung 300 als erstes Steuertelegramm T(K2) ein Steuertelegramm mit der Pseudozufallszahl 7824, so wird sie dieses Steuertelegramm als gültig erkennen und für eine vorgegebene Zeitdauer von beispielsweise 100 Millisekunden ein Steuersignal ST2 zum Schließen des Schalters S2 der Entscheidereinrichtung 400 generieren. In entsprechender Weise wird das Steuersignal ST2 jeweils für eine vorgegebene Zeitdauer erzeugt, wenn weitere Steuertelegramme T(K2) in der Empfangseinrichtung 300 eingehen, die mit der jeweils nächsten Pseudozufallszahl 9238, 4279, 4379, ... der empfängerindividuellen Pseudozufallszahlensequenz versehen sind.

Zusammengefasst wird ein Steuerbefehl SB, der am Eingang der Sendeeinrichtung 100 eingespeist wird, also über empfängerindividuelle Steuertelegramme T(K1) und T(K2) zu den beiden Empfangseinrichtungen 200 und 300 übersandt, die jeweils bei Empfang eines gültigen Steuertelegramms für eine vorgegebene Zeitdauer Steuersignale ST1 bzw. ST2 zum Aktivieren des Aktuators 500 bilden. Die Gültigkeit von Steuertelegrammen wird anhand empfängerindividueller Kontrollangaben überprüft, die bei dem Ausführungsbeispiel gemäß Figur 1 mit Hilfe eines Pseudozufallszahlengenerators und empfängerindividueller Startwerte SW1 und SW2 gebildet werden.

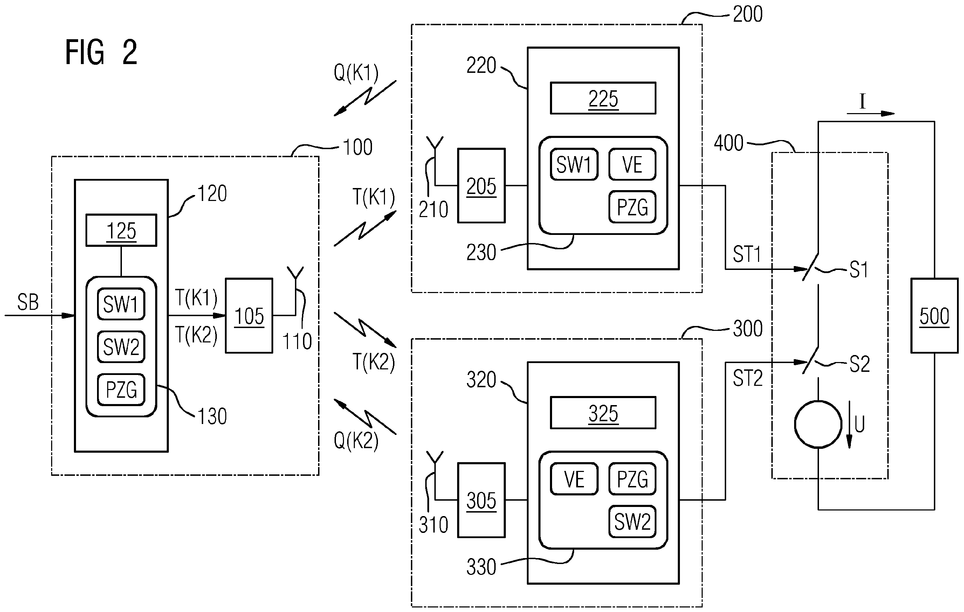

Die Figur 2 zeigt eine Variante der Anordnung gemäß Figur 1. Bei der Variante gemäß Figur 2 erzeugen die Empfangseinrichtungen 200 und 300 nach Empfang eines gültigen Steuertelegramms T(K1) und T(K2) jeweils ein Quittungssignal Q(K1) bzw. Q(K2), mit dem sie den Empfang eines gültigen Steuertelegramms quittieren. Vorzugsweise ist in den Quittungssignalen Q(K1) bzw. Q(K2) jeweils verschlüsselt oder unverschlüsselt die Telegrammnummer oder die der jeweiligen Telegrammnummer entsprechende Pseudozufallszahl der empfängerseitig zugeordneten Pseudozufallszahlensequenz enthalten. Die Recheneinrichtung 120 der Sendeeinrichtung 100 kann somit nachvollziehen, wie viele der ausgesandten Steuertelegramme T(K1) und T(K2) empfängerseitig empfangen und verarbeitet worden sind. Stellt die Sendeeinrichtung 100 fest, dass die Differenz zwischen der Anzahl gesendeter Steuertelegramme T(K1) und T(K2) und der Anzahl erhaltender Quittungstelegramme Q(K1) und Q(K2) einen vorgegebenen Differenzwert überschreitet, so wird sie davon ausgehen, dass die Übertragung der Steuertelegramme nicht fehlerfrei funktioniert und das Senden weiterer Steuertelegramme einstellen. In einem solchen Fall werden die Empfangseinrichtungen 200 und 300 nachfolgend die Erzeugung weiterer Steuersignale ST1 und ST2 einstellen, so dass die Entscheidereinrichtung 400 den Aktuator 500 deaktivieren wird.

Bei den Ausführungsbeispielen gemäß den Figuren 1 und 2 erfolgt das Übertragen der Steuertelegramme T(K1) und T(K2) sowie auch das Übertragen der Quittungstelegramme Q(K1) und Q(K2) über eine Funkverbindung. Alternativ oder zusätzlich ist es selbstverständlich möglich, die Steuertelegramme sowie die Quittungstelegramme auf andere Weise zu übertragen, beispielsweise draht- oder kabelgebunden, insbesondere mit Hilfe elektrischer oder optischer Signale. Alternativ ist auch eine Übertragung mittels Infrarot oder anderer Strahlung denkbar.

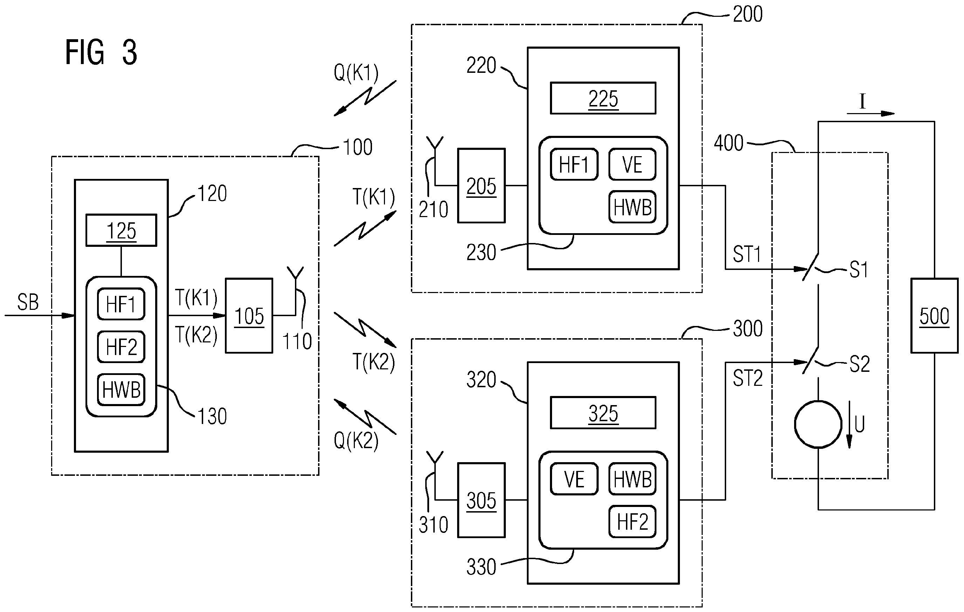

Die Figur 3 zeigt ein weiteres Ausführungsbeispiel für eine Anordnung mit einer Sendeeinrichtung 100, zwei Empfangseinrichtungen 200 und 300, einer Entscheidereinrichtung 400 sowie einem Aktuator 500.

Hardwaremäßig entspricht die Anordnung gemäß Figur 3 der Anordnung gemäß den Figuren 1 und 2. Unterschiedlich ist lediglich die Programmierung der Prozessoren 125, 225 und 325 bezüglich der Erzeugung von Kontrollangaben, mit denen sich die Gültigkeit der Steuertelegramme T(K1) und T(K2) überprüfen lässt.

Wie sich in der Figur 3 erkennen lässt, sind in den Speichern 130, 230 und 330 keine Generatormodule PZG zur Erzeugung von Pseudozufallszahlensequenzen, geschweige denn Startwerte SW1 und SW2 für derartige Generatormodule PZG abgespeichert. Stattdessen sind bei der Anordnung gemäß Figur 3 in den Speichern 130, 230 und 330 jeweils ein Hashwertbildner HWB sowie empfängerindividuelle Hashfunktionen HF1 und HF2 abgespeichert. Die Funktionsweise der Hashwertbildner HWB sowie die Funktion der empfängerindividuellen Hashfunktionen HF1 und HF2 soll nachfolgend beispielhaft näher erläutert werden:
Die Sendeeinrichtung 100 wird bei der Erzeugung der empfängerindividuellen Steuertelegramme T(K1) und T(K2) als empfängerindividuelle Kontrollangabe jeweils einen empfängerindividuellen und telegrammnummernindividuellen Hashwert erzeugen. Will die Sendeeinrichtung 100 beispielsweise ein erstes Steuertelegramm T(K1) zur Empfangseinrichtung 200 übersenden, so wird sie die Telegrammnummer "1" des ersten Steuertelegramms mit Hilfe der empfängerindividuellen Hashfunktion HF1, die der Empfangseinrichtung 200 zugewiesen ist, mit dem Hashwertbildner HWB bearbeiten und einen Hashwert erzeugen, der aufgrund der Anwendung der empfängerindividuellen Hashfunktion HF1 unter Berücksichtigung der Telegrammnummer "1" sowohl empfängerindividuell als auch telegrammnummernindividuell ist. Der Hashwert wird zu dem Steuertelegramm T(K1) hinzugefügt und mit diesem zur Empfangseinrichtung 200 übertragen.

Die Empfangseinrichtung 200 weist einen entsprechenden Hashwertbildner HWB wie die Sendeeinrichtung 100 auf, so dass sie in der Lage ist, unter Berücksichtigung der empfängerindividuellen Hashfunktion HF1, die in dem Speicher 230 abgespeichert ist, für die erste Telegrammnummer "1" einen eigenen Hashwert zu bilden, der dem in dem empfangenen Steuertelegramm T(K1) enthaltenen Hashwert entsprechen muss. Ist dies der Fall, so kann die Empfangseinrichtung 200 daran erkennen, dass das empfangene Steuertelegramm T(K1) für sie bestimmt ist und die richtige Telegrammnummer aufweist und somit gültig ist. In diesem Falle wird sie für eine vorgegebene Zeitdauer ein Steuersignal ST1 zum Einschalten des Schalters S1 erzeugen, wie dies bereits im Zusammenhang mit der Figur 1 erläutert worden ist.

In entsprechender Weise wird die Recheneinrichtung 120 für die weiteren Steuertelegramme T(K1), die zur Empfangseinrichtung 200 übersandt werden, jeweils weitere empfänger- und telegrammnummernindividuelle Hashwerte bilden und den Steuertelegrammen beifügen, so dass die Empfangseinrichtung 200 daran erkennen kann, dass die Steuertelegramme in der richtigen Reihenfolge erzeugt worden sind und tatsächlich auch für die Empfangseinrichtung 200 bestimmt sind.

Analog wird die Recheneinrichtung 120 empfängerindividuelle Hashwerte für die Steuertelegramme T(K2) bilden, die zur Empfangseinrichtung 300 gesandt werden. Die Hashwerte für die Empfangseinrichtung 300 werden dabei mit der empfängerindividuellen Hashfunktion HF2 erzeugt, die in dem Speicher 130 der Recheneinrichtung 120 gespeichert ist.

Die Steuertelegramme T(K2), die in der Empfangseinrichtung 300 eingehen, können somit von der Recheneinrichtung 320 ebenfalls auf Gültigkeit erkannt werden, indem unter Berücksichtigung der aktuellen Telegrammnummer des erwarteten Telegramms mit Hilfe des eigenen Hashwertbildners HWB, der im Speicher 330 abgespeichert ist, ein Referenzhashwert gebildet wird und dieser mittels des Vergleichsmoduls VE mit dem Hashwert des empfangenen Steuertelegramms T(K2) verglichen wird. Nur dann, wenn der Hashwert im empfangenen Steuertelegramm T(K2) mit dem selbst gebildeten bzw. erwarteten Hashwert übereinstimmt, wird die Recheneinrichtung 320 für eine vorgegebene Zeitdauer ein Steuersignal ST2 zum Aktivieren des Schalters S2 erzeugen.

Im Übrigen entspricht die Arbeitsweise der Anordnung gemäß Figur 3 der Arbeitsweise gemäß den Figuren 1 und 2. So kann auch bei der Anordnung gemäß Figur 3 durch das Übersenden von Quittungssignalen Q(K1) und Q(K2) erreicht werden, dass die Sendeeinrichtung 100 überprüfen kann, ob die von ihr gesendeten Steuertelegramme T(K1) und T(K2) tatsächlich in den beiden Empfangseinrichtungen 200 und 300 eingehen. Stellt die Steuereinrichtung 100 fest, dass die Differenz zwischen der Anzahl der gesendeten Steuertelegramme T(K1) bzw. T(K2) und die Anzahl erhaltener Quittungstelegramme Q(1) bzw. Q(K2) einen vorgegebenen Differenzwert überschreitet, so wird sie das Senden weiterer Steuertelegramme vorzugsweise einstellen, so dass der Aktuator 500 deaktiviert wird. Vorzugsweise ist in den Quittungssignalen Q(K1) bzw. Q(K2) jeweils verschlüsselt oder unverschlüsselt die Telegrammnummer oder der der jeweiligen Telegrammnummer entsprechende Hashwert, der mit der empfängerseitig zugeordneten Hashfunktion gebildet wird, enthalten.

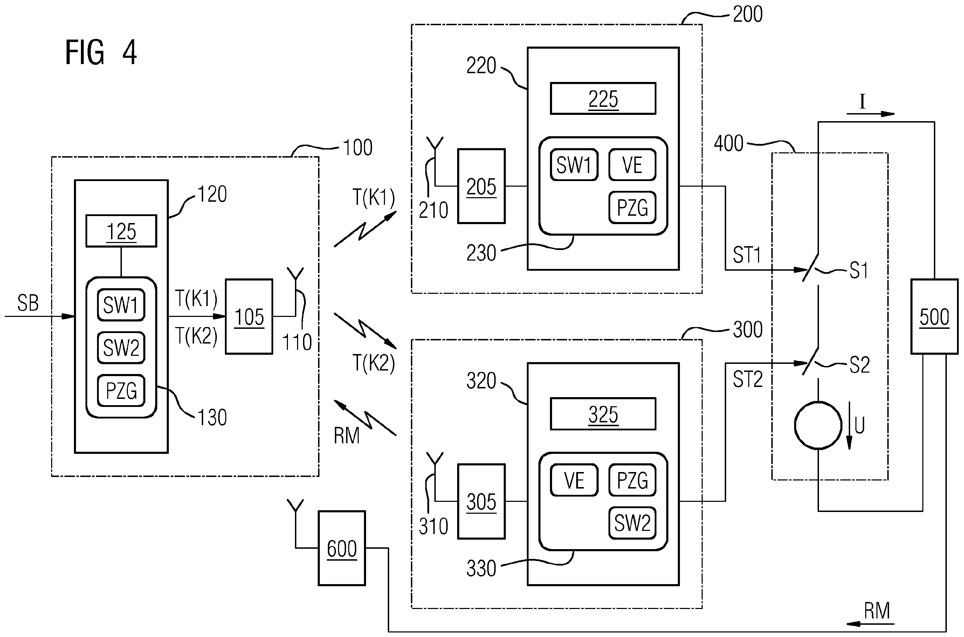

Die Figur 4 zeigt ein weiteres Ausführungsbeispiel für eine Anordnung mit einer Sendeeinrichtung 100, einer Empfangseinrichtung 200, einer weiteren Empfangseinrichtung 300, einer Entscheidereinrichtung 400 sowie einem Aktuator 500. Im Unterschied zu den Ausführungsbeispielen gemäß den Figuren 1 bis 3 ist bei der Anordnung gemäß Figur 4 zusätzlich eine Rückmeldeeinrichtung 600 vorhanden, die den Schaltzustand des Aktuators 500 überwacht und ein Rückmeldesignal RM an die Sendeeinrichtung 100 übermittelt, das den tatsächlichen Schaltzustand des Aktuators 500 anzeigt. Sendeseitig kann somit kontrolliert werden, ob der gewünschte Schaltzustand des Aktuators 500 tatsächlich erreicht wird. Im Übrigen sei auf die obigen Ausführungen im Zusammenhang mit den Figuren 1 bis 3 verwiesen.

Bei den obigen Ausführungsbeispielen gemäß den Figuren 1 bis 4 bilden die beiden Empfangseinrichtungen 200 und 300, die Entscheidereinrichtung 400 und der Aktuator 500 eine Empfangsanordnung mit integriertem Aktuator für einen sicheren Empfang von Steuerbefehlen.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Anordnung mit einem Aktuator (500), zumindest einer Sendeeinrichtung (100) zum Senden von Steuertelegrammen (T(K1), T(K2)), die jeweils einen vorgegebenen Steuerbefehl (SB) für den Aktuator (500) enthalten oder als solche den vorgegebenen Steuerbefehl (SB) selbst bilden, mindestens zwei Empfangseinrichtungen (200, 300) zum Empfangen der Steuertelegramme (T(K1), T(K2)) und Erzeugen eines Steuersignals (ST1, ST2) für den Aktuator (500), und einer die Empfangseinrichtungen (200, 300) mit dem Aktuator (500) verbindenden Entscheidereinrichtung (400), die ein Umsetzen der Steuersignale (ST1, ST2) der Empfangseinrichtungen (200, 300) durch den Aktuator (500) mittels eines Freigabesignals ausschließlich dann erlaubt, wenn von allen Empfangseinrichtungen (200, 300) oder zumindest einer vorgegebenen Mindestzahl an Empfangseinrichtungen (200, 300) das Steuersignal (ST1, ST2) vorliegt,
- wobei die Sendeeinrichtung (100) derart ausgestaltet ist, dass sie den vorgegebenen Steuerbefehl (SB) jeweils an jede Empfangseinrichtung (200, 300) mit einem empfängerindividuellen Steuertelegramm (T(K1), T(K2)) übersendet, wobei jedes empfängerindividuelle Steuertelegramm (T(K1), T(K2)) jeweils mit einer Kontrollangabe versehen wird, die die fortlaufende Telegrammnummer des jeweils gesendeten Steuertelegramms (T(K1), T(K2)) in verschlüsselter oder unverschlüsselter Form angibt, und
- wobei jede der mindestens zwei Empfangseinrichtungen (200, 300) derart ausgestaltet ist, dass sie ein empfangenes Steuertelegramm (T(K1), T(K2)) anhand der Kontrollangabe als für sie gültig akzeptiert, wenn die Kontrollangabe eine Telegrammnummer angibt, die der empfängerseitig erwarteten fortlaufenden Telegrammnummer entspricht, und im Falle des Empfangs eines gültigen Steuertelegramms (T(K1), T(K2)) das Steuersignal(ST1, ST2) für den Aktuator (500) jeweils für eine vorgegebene Zeitdauer erzeugt.

2. Anordnung nach Anspruch 1,
**dadurch gekennzeichnet, dass** die Sendeeinrichtung (100) einen Kontrollangabengenerator aufweist, der für jede Empfangseinrichtung (200, 300) in Abhängigkeit von der fortlaufenden Telegrammnummer des zu sendenden Steuertelegramms (T(K1), T(K2)) und einer empfängerindividuellen Saatangabe oder einem empfängerindividuellen Saatwert die Kontrollangabe empfängerindividuell erzeugt.

3. Anordnung nach Anspruch 2,
**dadurch gekennzeichnet, dass**
- der Kontrollangabengenerator einen Pseudozufallszahlengenerator aufweist und die empfängerindividuellen Saatwerte empfängerindividuelle Startwerte (SW1, SW2) für den Pseudozufallszahlengenerator sind und
- der Kontrollangabengenerator empfängerindividuelle Pseudozufallszahlensequenzen bildet, die der Telegrammnummernsequenz zugeordnet werden, und als empfängerindividuelle Kontrollangabe die der aktuellen Telegrammnummer des zu sendenden Telegramms (T(K1), T(K2)) entsprechende Pseudozufallszahl der jeweiligen empfängerindividuellen Pseudozufallszahlensequenz ausgewählt wird.

4. Anordnung nach Anspruch 3,
**dadurch gekennzeichnet, dass** jede Empfangseinrichtung (200, 300) jeweils einen Referenzpseudozufallszahlengenerator und eine Vergleichseinrichtung aufweist,
- wobei der Referenzpseudozufallszahlengenerator geeignet ist, mit dem empfängerindividuellen Startwert (SW1, SW2) die empfängerindividuelle Pseudozufallszahlensequenz zu generieren, und
- wobei die Vergleichseinrichtung derart ausgestaltet ist, dass sie für jedes empfangene Telegramm (T(K1), T(K2)) anhand der fortlaufenden Telegrammnummer prüft, ob die übermittelte Pseudozufallszahl der erwarteten Pseudozufallszahl gemäß Pseudozufallszahlensequenz entspricht und den Steuerbefehl (SB) erzeugt, wenn der Vergleich der Kontrollangabe eine Übereinstimmung zeigt.

5. Anordnung nach Anspruch 4,
**dadurch gekennzeichnet, dass** die Vergleichseinrichtung derart ausgestaltet ist, dass sie die übermittelte Pseudozufallszahl als erwartete Pseudozufallszahl gemäß Pseudozufallszahlensequenz ansieht, wenn diese in einen durch eine vorgegebene Anzahl an sequenzmäßig aufeinanderfolgenden Pseudozufallszahlen definierten Sequenzabschnitt fällt, in dem auch die empfängerseitig anhand der fortlaufenden Telegrammnummer (T(K1), T(K2)) erwartete Pseudozufallszahl liegt.

6. Anordnung nach einem der Ansprüche 2 bis 5, **dadurch gekennzeichnet, dass** der Kontrollangabengenerator der Sendeeinrichtung (100) einen Hashwertbildner (HWB) umfasst, der mit der aktuellen Telegrammnummer der Telegrammnummernsequenz und einer empfängerindividuellen Hashfunktion (HF1, HF2) als empfängerindividuelle Kontrollangabe einen empfängerindividuellen Hashwert erzeugt.

7. Anordnung nach Anspruch 6,
**dadurch gekennzeichnet, dass** jede Empfangseinrichtung (200, 300) jeweils einen Referenzhashwertbildner und eine Vergleichseinrichtung aufweist,
- wobei der Referenzhashwertbildner geeignet ist, mit der empfängerindividuellen Hashfunktion (HF1, HF2) und der anhand der fortlaufenden Telegrammnummer des zuvor empfangenen Telegramms (T(K1), T(K2)) erwarteten Telegrammnummer des nächsten Telegramms (T(K1), T(K2)) einen Referenzhashwert zu generieren, und
- wobei die Vergleichseinrichtung derart ausgestaltet ist, dass sie für jedes empfangene Telegramm (T(K1), T(K2)) prüft, ob der übermittelte Hashwert dem Referenzhashwert entspricht und den Steuerbefehl (SB) erzeugt, wenn der Vergleich eine Übereinstimmung zeigt.

8. Anordnung nach einem der voranstehenden Ansprüche,
**dadurch gekennzeichnet, dass**
- die Anordnung eine Steueranordnung zum Steuern eines Aktuators (500) eines Schienenfahrzeugs bildet und
- die Sendeeinrichtung (100) derart ausgebildet ist, dass sie als Steuerbefehl (SB) einen Befehl zum Beibehalten einer aktiven Aktuatorstellung erzeugt, und
- der Aktuator (500) derart ausgestaltet ist, dass er in seine passive Aktuatorstellung zurückfällt, wenn von der Entscheidereinrichtung (400) kein Freigabesignal vorliegt.

9. Anordnung nach einem der voranstehenden Ansprüche,
**dadurch gekennzeichnet, dass**
- die Empfangseinrichtungen (200, 300) derart ausgestaltet sind, dass sie den Empfang von Steuertelegrammen (T(K1), T(K2)) jeweils durch ein Übersenden eines Quittungstelegramms (Q(K1), Q(K2) mit empfänger- und telegrammnummernindividueller Kontrollangabe an die Sendeeinrichtung (100) quittieren, und
- die Sendeeinrichtung (100) derart ausgebildet ist, dass sie das Senden weiterer Steuertelegramme (T(K1), T(K2)) einstellt, wenn die Differenz zwischen der Anzahl gesendeter Steuertelegramme (T(K1), T(K2)) und der Anzahl erhaltener Quittungstelegramme (Q(K1), Q(K2) einen vorgegebenen Differenzwert überschreitet.

10. Anordnung nach einem der voranstehenden Ansprüche, **dadurch gekennzeichnet, dass** die Entscheidereinrichtung (400) durch ein UND-Glied gebildet ist, das das Freigabesignal für den Aktuator (500) ausschließlich dann bildet, wenn alle Empfangseinrichtungen (200, 300) das Steuersignal (ST1, ST2) erzeugt haben.

11. Empfangsanordnung für eine Anordnung nach einem der voranstehenden Ansprüche, wobei
- die Empfangsanordnung einen Aktuator (500), mindestens zwei Empfangseinrichtungen (200, 300) zum Empfangen von Steuertelegrammen (T(K1), T(K2)) und Erzeugen eines Steuersignals (ST1, ST2) für den Aktuator (500), und eine die Empfangseinrichtungen (200, 300) mit dem Aktuator (500) verbindende Entscheidereinrichtung (400) aufweist, die ein Umsetzen der Steuersignale (ST1, ST2) der Empfangseinrichtungen (200, 300) durch den Aktuator (500) mittels des Freigabesignals ausschließlich dann erlaubt, wenn von allen Empfangseinrichtungen (200, 300) oder zumindest einer vorgegebenen Mindestzahl an Empfangseinrichtungen (200, 300) das Steuersignal (ST1, ST2) vorliegt,
- wobei jede der mindestens zwei Empfangseinrichtungen (200, 300) derart ausgestaltet ist, dass sie ein empfangenes Steuertelegramm (T(K1), T(K2)) anhand einer Kontrollangabe als für sie gültig akzeptiert, wenn die Kontrollangabe eine Telegrammnummer angibt, die der empfängerseitig erwarteten fortlaufenden Telegrammnummer entspricht, und im Falle des Empfangs eines gültigen Steuertelegramms (T(K1), T(K2)) das Steuersignal (ST1, ST2) für den Aktuator (500) jeweils für eine vorgegebene Zeitdauer erzeugt.

12. Verfahren zum Betreiben einer Anordnung mit einem Aktuator (500), einer Sendeeinrichtung (100), mindestens zwei Empfangseinrichtungen (200, 300), und einer die Empfangseinrichtungen (200, 300) mit dem Aktuator (500) verbindenden Entscheidereinrichtung (400),
wobei bei dem Verfahren:
mit der Sendeeinrichtung (100) Steuertelegramme (T(K1), T(K2)) gesendet werden, die jeweils einen vorgegebenen Steuerbefehl (SB) für den Aktuator (500) enthalten oder als solche den vorgegebenen Steuerbefehl (SB) selbst bilden,
mit den mindestens zwei Empfangseinrichtungen (200, 300) die Steuertelegramme (T(K1), T(K2)) empfangen werden und Steuersignale (ST1, ST2) für den Aktuator (500) erzeugt werden, und
die Entscheidereinrichtung (400) ein Umsetzen der Steuersignale (ST1, ST2) der Empfangseinrichtungen (200, 300) durch den Aktuator (500) mittels eines Freigabesignals ausschließlich dann erlaubt, wenn von allen Empfangseinrichtungen (200, 300) oder zumindest einer vorgegebenen Mindestzahl an Empfangseinrichtungen (200, 300) das Steuersignal (ST1, ST2) vorliegt,
- wobei die Sendeeinrichtung (100) den vorgegebenen Steuerbefehl (SB) jeweils an jede Empfangseinrichtung (200, 300) mit einem empfängerindividuellen Steuertelegramm (T(K1), T(K2)) übersendet, wobei jedes empfängerindividuelle Steuertelegramm (T(K1), T(K2)) jeweils mit einer Kontrollangabe versehen wird, die die fortlaufende Telegrammnummer des jeweils gesendeten Steuertelegramms (T(K1), T(K2)) in verschlüsselter oder unverschlüsselter Form angibt, und
- wobei jede der mindestens zwei Empfangseinrichtungen (200, 300) ein empfangenes Steuertelegramm (T(K1), T(K2)) anhand der Kontrollangabe als für sie gültig akzeptiert, wenn die Kontrollangabe eine Telegrammnummer angibt, die der empfängerseitig erwarteten fortlaufenden Telegrammnummer entspricht, und im Falle des Empfangs eines gültigen Steuertelegramms (T(K1), T(K2)) das Steuersignal (ST1, ST2) für den Aktuator (500) jeweils für eine vorgegebene Zeitdauer erzeugt.

## Claims

1. Arrangement with an actuator (500), at least one transmit device (100) for transmitting control telegrams (T(K1), T(K2)) which each contain a predefined control command (SB) for the actuator (500) or as such themselves form the predefined control command (SB), at least two receive devices (200, 300) for receiving the control telegrams (T(K1), T(K2)) and generating a control signal (ST1, ST2) for the actuator (500), and a decider device (400) connecting the receive devices (200, 300) to the actuator (500) which allows a conversion of the control signals (ST1, ST2) of the receive devices (200, 300) by the actuator (500) by means of a release signal only if the control signal (ST1, ST2) is present from all receive devices (200, 300) or at least a predefined minimum number of receive devices (200, 300),
- wherein the transmit device (100) is designed in such a way that it transmits the predefined control command (SB) in each case to each receive device (200, 300) with a receiver-specific control telegram (T(K1), T(K2)), wherein each receiver-specific control telegram (T(K1), T(K2)) is provided in each case with a check datum indicating the consecutive number of the respectively transmitted control telegram (T(K1), T(K2)) in encrypted or unencrypted form, and
- wherein each of the at least two receive devices (200, 300) is designed in such a way that it accepts a received control telegram (T(K1), T(K2)) as valid for it on the basis of the check datum if the check datum indicates a telegram number which matches the consecutive telegram number expected at the receiving end and, if a valid control telegram (T(K1), T(K2)) is received, generates the control signal (ST1, ST2) for the actuator (500) in each case for a predefined time duration.

2. Arrangement according to Claim 1,
**characterized in that**
the transmit device (100) has a check datum generator which generates the check datum in a receiver-specific manner for each receive device (200, 300) depending on the consecutive telegram number of the control telegram (T(K1), T(K2)) to be transmitted and a receiver-specific seed datum or a receiver-specific seed value.

3. Arrangement according to Claim 2,
**characterized in that**
- the check datum generator has a pseudorandom number generator and the receiver-specific seed values are receiver-specific start values (SW1, SW2) for the pseudorandom number generator and
- the check datum generator forms receiver-specific pseudorandom number sequences which are allocated to the telegram number sequence, and the pseudorandom number of the respective receiver-specific pseudorandom number sequence corresponding to the current telegram number of the telegram (T(K1), T(K2)) to be transmitted is selected as the receiver-specific check datum.

4. Arrangement according to Claim 3,
**characterized in that**
each receive device (200, 300) in each case has a reference pseudorandom number generator and a comparison device,
- wherein the reference pseudorandom number generator is suitable for generating the receiver-specific pseudorandom number sequence with the receiver-specific start value (SW1, SW2), and
- wherein the comparison device is designed in such a way that it checks for each receive telegram (T(K1), T(K2)), on the basis of the consecutive telegram number, whether the transmitted pseudorandom number matches the expected pseudorandom number according to the pseudorandom number sequence, and generates the control command (SB) if the comparison of the check datum shows a match.

5. Arrangement according to Claim 4,
**characterized in that**
the comparison device is preferably designed in such a way that it regards the transmitted pseudorandom number as the expected pseudorandom number according to the pseudorandom number sequence if it falls within a sequence segment defined by a predefined number of sequentially consecutive pseudorandom numbers, in which segment the pseudorandom number expected on the basis of the consecutive telegram number (T(K1), T(K2)) also lies.

6. Arrangement according to one of Claims 2 to 5, **characterized in that**
the check datum generator of the transmit device (100) may comprise a hash value (HWB) former which generates a receiver-specific hash value with the current telegram number of the telegram number sequence and a receiver-specific hash function (HF1, HF2) as a receiver-specific hash value.

7. Arrangement according to Claim 6,
**characterized in that**
each receive device (200, 300) in each case has a reference hash value former and a comparison device,
- wherein the reference hash value former is suitable for generating a reference hash value with the receiver-specific hash function (HF1, HF2) and the telegram number of the next telegram (T(K1), T(K2)) expected on the basis of the consecutive telegram number of the previously received telegram (T(K1), T(K2)), and
- wherein the comparison device is designed in such a way that it checks for each received telegram (T(K1), T(K2)) whether the transmitted hash value matches the reference hash value and generates the control command (SB) if the comparison shows a match.

8. Arrangement according to one of the preceding claims, **characterized in that**
- Arrangement forms a control arrangement to control an actuator (500) of a rail vehicle, and
- the transmit device (100) is designed in such a way that it generates a command for retaining an active actuator setting as a control command (SB), and
- the actuator (500) is designed in such a way that it reverts to a passive actuator setting if no release signal is present from the decider device (400).

9. Arrangement according to one of the preceding claims, **characterized in that**
- the receive devices (200, 300) are designed in such a way that they acknowledge the receipt of control telegrams (T(K1), T(K2)) in each case by a transmission of an acknowledgement telegram (Q(K1), Q(K2)) with a receiver-specific and telegram-number-specific check datum to the transmit device, and
- the transmit device (100) is designed in such a way that it sets the transmission of further control telegrams (T(K1), T(K2)) if the difference between the number of transmitted control telegrams (T(K1), T(K2)) and the number of received acknowledgement telegrams (Q(K1), Q(K2)) exceeds a predefined differential value.

10. Arrangement according to one of the preceding claims, **characterized in that**
the decider device (400) is formed by an AND element which forms the release signal for the actuator (500) only if all receive devices (200, 300) have generated the control signal (ST1, ST2).

11. Receive arrangement for an arrangement according to one of the preceding claims,
wherein
- the receive arrangement has an actuator (500), at least two receive devices (200, 300) for receiving control telegrams (T(K1), T(K2)) and generating a control signal (ST1, ST2) for the actuator (500), and a decider device (400) connecting the receive devices (200, 300) to the actuator (500), which allows a conversion of the control signals (ST1, ST2) of the receive devices (200, 300) by the actuator (500) by means of the release signal only if the control signal (ST1, ST2) is present from all receive devices (200, 300) or at least a predefined minimum number of receive devices (200, 300),
- wherein each of the at least two receive devices (200, 300) is designed in such a way that it accepts a received control telegram (T(K1), T(K2)) as valid for it on the basis of a check datum if the check datum indicates a telegram number which matches the consecutive telegram number expected at the receiving end, and, if a valid control telegram (T(K1), T(K2)) is received, generates the control signal (ST1, ST2) for the actuator (500) in each case for a predefined time duration.

12. Method for operating an arrangement with an actuator (500), a transmit device (100), at least two receive devices (200, 300), and a decider device (400) connecting the receive devices (200, 300) to the actuator (400),
wherein, in the method:
- control telegrams (T(K1), T(K2)) which in each case contain a predefined control command (SB) for the actuator (500) or as such themselves form the predefined control command (SB) are transmitted with the transmit device (100),
- the control telegrams (T(K1), T(K2)) are received and control signals are generated for the actuator (500) with the at least two receive devices (200, 300), and
- the decider device (400) allows a conversion of the control signals (ST1, ST2) of the receive devices (200, 300) by the actuator (500) by means of a release signal only if the control signal (ST1, ST2) is present from all receive devices (200, 300) or at least a predefined minimum number of receive devices (200, 300),
- wherein the transmit device (100) transmits the predefined control command (SB) in each case to each receive device (200, 300) with a receiver-specific control telegram (T(K1), T(K2)), wherein each receiver-specific control telegram (T(K1), T(K2)) is in each case provided with a check datum which indicates the consecutive telegram number of the respectively transmitted control telegram (T(K1), T(K2)) in encrypted or unencrypted form, and
- wherein each of the at least two receive devices (200, 300) accepts a received control telegram (T(K1), T(K2)) as valid for it on the basis of the check datum if the check datum indicates a telegram number which matches the consecutive telegram number expected of the receiving end, and, if a valid control telegram (T(K1), T(K2)) is received, generates the control signal (ST1, ST2) for the actuator (500) in each case for a predefined time duration.

## Revendications

1. Agencement comprenant un actionneur (500), au moins un dispositif (100) d'émission, pour envoyer des télégrammes (T(K1), T(K2)) de commande, qui contiennent respectivement une instruction (SB) de commande donnée à l'avance de l'actionneur (500) ou forment en tant que telle l'instruction (SB) de commande donnée à l'avance, au moins deux dispositifs (200, 300) de réception des télégrammes (T(K1), T(K2)) de commande et de production d'un signal (ST1, ST2) de commande de l'actionneur (500) et un dispositif (400) de décision reliant les dispositifs (200, 300) de réception à l'actionneur (500) et permettant, au moyen d'un signal de libération, une transformation des signaux (ST1, ST2)) de commande des dispositifs (200, 300) de réception par l'actionneur (500), exclusivement si le signal (ST1, ST2) de commande est produit par tous les dispositifs (200, 300) de réception, ou au moins par un nombre minimum donné à l'avance de dispositifs (200, 300) de réception,
- dans lequel le dispositif (100) d'émission est conformé de manière à faire parvenir l'instruction (SB) de commande donnée à l'avance respectivement à chaque dispositif (200, 300) de réception, avec un télégramme (T(K1), T(K2)) de commande individuelle au récepteur, chaque télégramme (T(K1), T(K2)) de commande individuelle au récepteur étant pourvu respectivement d'une indication de contrôle, qui indique, sous forme chiffrée ou non chiffrée, le numéro d'ordre du télégramme (T(K1), T(K2)) de commande envoyé et
- dans lequel chacun des au moins deux dispositifs (200, 300) de réception est conformé de manière à accepter comme valable pour lui, au moyen de l'indication de contrôle, un télégramme (T(K1), T(K2)) de commande reçu, si l'indication de contrôle indique un numéro de télégramme qui correspond au numéro d'ordre du télégramme attendu de la part du récepteur et, dans le cas de la réception d'un télégramme (T(K1), T(K2)) de commande valable, à produire le signal (ST1, ST2) de commande de l'actionneur (500) pendant une durée donnée à l'avance.

2. Agencement suivant la revendication 1,
**caractérisé en ce que**
le dispositif (100) d'émission a un générateur d'indication de contrôle, qui produit individuellement au récepteur l'indication de contrôle pour chaque dispositif (200, 300) de réception, en fonction du numéro d'ordre du télégramme (T(K1), T(K2)) de commande à envoyer et d'une indication de graine individuelle au récepteur ou d'une valeur de graine individuelle au récepteur.

3. Agencement suivant la revendication 2,
**caractérisé en ce que**
- le générateur d'indication de contrôle a un générateur de nombres pseudoaléatoires et les valeurs de graine individuelles au récepteur sont des valeurs (SW1, SW2) de début individuelles au récepteur pour le générateur de nombres pseudoaléatoires et
- le générateur d'indication de contrôle forme des séquences individuelles au récepteur de nombres pseudoaléatoires, qui sont affectées à la séquence de numéro de télégramme et il est choisi comme indication de contrôle individuelle au récepteur le nombre pseudoaléatoire, correspondant au numéro en cours du télégramme (T(K1), T(K2)) à envoyer, de la séquence de nombres pseudoaléatoires individuelle au récepteur.

4. Agencement suivant la revendication 3,
**caractérisé en ce que**
chaque dispositif (200, 300) de réception a un générateur de nombres pseudoaléatoires de référence et un dispositif de comparaison,
- dans lequel le générateur de nombres pseudoaléatoires de référence est propre à produire, avec la valeur (SW1, SW2) de début individuelle au récepteur, la séquence de nombres pseudoaléatoires individuelle au récepteur et
- dans lequel le dispositif de comparaison est conformé de manière à contrôler, pour chaque télégramme (T(K1), T(K2)) reçu, à l'aide du numéro d'ordre du télégramme, si le nombre pseudoaléatoire transmis correspond au nombre pseudoaléatoire auquel on s'attend, suivant la séquence de nombres pseudoaléatoires et produit l'instruction (SB) de commande si la comparaison de l'indication de contrôle montre une coïncidence.

5. Agencement suivant la revendication 4,
**caractérisé en ce que**
le dispositif de comparaison est conformé de manière à considérer le nombre pseudoaléatoire transmis comme le nombres pseudoaléatoires auquel on s'attend suivant la séquence de nombres pseudoaléatoires, si celui-ci tombe dans une partie de séquence définie par un nombre donné à l'avance de nombres pseudo aléatoires se succédant suivant la séquence, partie dans laquelle se trouve aussi le nombres pseudoaléatoires auquel on s'attend du côté du récepteur, à l'aide du numéro (T(K1), T(K2)) d'ordre du télégramme.

6. Agencement suivant l'une des revendications 2 à 5, **caractérisé en ce que**
le générateur d'indication de contrôle du dispositif (100) d'émission comprend un formateur (HWB) de valeur de Hash, qui produit, avec le numéro en cours du télégramme de la séquence de numéros de télégramme et d'une fonction (HF1, HF2) de Hash individuelle au récepteur, une valeur de Hash individuelle au récepteur comme indication de contrôle individuelle au récepteur.

7. Agencement suivant la revendication 6,
**caractérisé en ce que**
chaque dispositif (200, 300) de réception a respectivement un formateur de valeur de Hash de référence et un dispositif de comparaison,
- dans lequel le formateur de valeur de Hash de référence est propre, avec la fonction (HF1, HF2) de Hash individuelle au récepteur et le numéro du télégramme (T(K1), T(K2)) suivant auquel on s'attend, à l'aide du numéro en cours du télégramme (T(K1), T(K2)) reçu auparavant, à produire une valeur de Hash de référence et
- dans lequel le dispositif de comparaison est conformé pour contrôler, pour chaque télégramme (T(K1), T(K2)) reçu, si la valeur de Hash transmise correspond à la valeur de Hash de référence, et pour produire l'instruction (SB) de commande, si la comparaison montre une coïncidence.

8. Agencement suivant l'une des revendications précédentes, **caractérisé en ce que**
- l'agencement forme un agencement de commande d'un actionneur (500) d'un véhicule ferroviaire et
- le dispositif (100) d'émission est constitué de manière à produire comme instruction (SB) de commande une instruction de conservation d'une position active de l'actionneur et
- l'actionneur (500) est conformé de manière à revenir dans sa position passive d'actionneur, s'il n'y a pas de signal de libération donné par le dispositif (400) de décision.

9. Agencement suivant l'une des revendications précédentes, **caractérisé en ce que**
- les dispositifs (200, 300) de réception sont conformés de manière à accuser de la réception de télégrammes (T(K1), T(K2)) de commande, par envoi au dispositif (100) d'émission d'un télégramme (Q(K1), Q(K2) d'accusé de réception ayant une indication de contrôle individuelle au récepteur et au numéro du télégramme et
- le dispositif (100) d'émission est conformé de manière à cesser l'envoi d'autres télégrammes (T(K1), T(K2)) de commande, si la différence entre le nombre de télégrammes (T(K1), T(K2)) de commande envoyés et le nombre de télégrammes (Q(K1), Q(K2) d'accusé de réception obtenue dépasse une valeur de différence données à l'avance.

10. Agencement suivant l'une des revendications précédentes, **caractérisé en ce que**
le dispositif (400) de décision est formé par un élément ET, qui forme le signal de libération de l'actionneur (500), exclusivement lorsque tous les dispositifs (200, 300) de réception ont produit le signal (ST1, ST2) de commande.

11. Agencement de réception pour un agencement suivant l'une des revendications précédentes,
dans lequel
- l'agencement de réception a un actionneur (500), au moins deux dispositifs (200, 300) de réception de télégramme (T(K1), T(K2)) de commande et de production d'un signal (ST1, ST2) de commande de l'actionneur (500) et un dispositif (400) de décision reliant les dispositifs (200, 300) de réception à l'actionneur (500) et permettant une transformation des signaux (ST1, ST2) de commande des dispositifs (200, 300) de réception par l'actionneur (500), au moyen du signal de libération, exclusivement lorsque le signal (ST1, ST2) de commande est donné par tous les dispositifs (200, 300) de réception ou par au moins un nombre minimum donné à l'avance des dispositifs (200, 300) de réception,
- dans lequel chacun des au moins deux dispositifs (200, 300) de réception est conformé de manière à accepter comme valable pour lui, au moyen d'une indication de contrôle, un télégramme (T(K1), T(K2)) de commande reçu, si l'indication de contrôle indique un numéro de télégramme qui correspond au numéro d'ordre du télégramme auquel on s'attend du côté du récepteur et, dans le cas de la réception d'un télégramme (T(K1), T(K2)) de commande valable, produit le signal (ST1, ST2) de commande de l'actionneur (500) pendant une durée donnée à l'avance.

12. Procédé pour faire fonctionner un agencement comprenant un actionneur (500), un dispositif (100) d'émission, au moins deux dispositifs (200, 300) de réception et un dispositif (400) de décision reliant les dispositifs (200, 300) de réception à l'actionneur (500),
procédé dans lequel :
on envoie, par le dispositif (100) d'émission, des télégrammes (T(K1), T(K2)) de commande, qui contiennent respectivement une instruction (SB) de commande donnée à l'avance de l'actionneur (500), ou qui forment eux-mêmes en tant que tels, l'instruction (SB) de commande donnée à l'avance,
on reçoit, par les au moins deux dispositifs (200, 300) de réception, des télégrammes (T(K1), T(K2)) de commande et on produit des signaux (ST1, ST2) de commande de l'actionneur (500) et le dispositif (400) de décision permet une transformation des signaux (ST1, ST2) de commande des dispositifs (200, 300) de réception par l'actionneur (500) au moyen d'un signal de libération, exclusivement lorsqu'il est donné par tous les dispositifs (200, 300) de réception, ou par au moins un nombre minimum donné à l'avance de dispositifs (200, 300) de réception, le signal (ST1, ST2) de commande,
- dans lequel le dispositif (100) d'émission transmet l'instruction (SB) de commande donnée à l'avance à chaque dispositif (200, 300) d'émission, par un télégramme (T(K1), T(K2)) de commande individuel au récepteur, chaque télégramme T(K1), T(K2)) de commande individuel au récepteur étant pourvu respectivement d'une indication de contrôle, qui indique le numéro d'ordre du télégramme (T(K1), T(K2)) de commande envoyé, sous forme chiffrée ou sous forme non chiffrée et
- dans lequel chacun des au moins deux dispositifs (200, 300) de réception accepte comme valable pour lui, à l'aide de l'indication de commande, un télégramme (T(K1), T(K2)) de commande reçu, si l'indication de commande indique un numéro de télégramme qui correspond au numéro d'ordre du télégramme auquel on s'attend du côté du récepteur et, dans le cas de la réception d'un télégramme (T(K1), T(K2)) de commande valable, produit le signal (ST1, ST2) de commande de l'actionneur (500) pendant une durée donnée à l'avance.
